# EUROPEAN PATENT SPECIFICATION

(11) **EP 0 788 722 B1**
(45) Date of publication and mention of the grant of the patent: **26.05.1999**
(21) Application number: 95901061.2
(22) Date of filing: 27.10.1994
(51) Int. Cl.: H03G 5/04, H04R 9/02

(54) **APPARATUS AND METHOD OF ENHANCING AUDIO SIGNALS**
VERFAHREN UND VORRICHTUNG ZUR VERBESSERUNG VON TONSIGNALEN
PROCEDE ET DISPOSITIF D'AMELIORATION DE SIGNAUX AUDIO

(43) Date of publication of application: 13.08.1997
(73) Proprietor: True Dimensional Sound, Inc., Coral Gables, Florida 33146 (US)
(72) Inventor: GARCIA, Arturo, J., Miami, FL 33032 (US)
(74) Representative: Cummings, Sean Patrick
(86) International application number: PCT/US94/12328
(87) International publication number: WO 96/13959

(56) References cited:
- GB-A- 2 137 427
- US-A- 4 692 852
- PATENT ABSTRACTS OF JAPAN vol. 13, no. 474 (E-836) 26 October 1989 & JP,A,01 186 008 (MATSUSHITA) 25 July 1989
- PATENT ABSTRACTS OF JAPAN vol. 15, no. 106 (E-1044) 13 March 1991 & JP,A,02 311 006 (PIONEER) 29 December 1990

## Description

### FIELD OF THE INVENTION

The present invention relates to apparatus and method for enhancing electronic audio signals in order to improve the quality of sound produced from those signals, and more particularly to an apparatus and method for adding enhancing harmonics to the electronic audio signal.

### BACKGROUND OF THE INVENTION

Hearing music, singing or other such sounds live has often been considered more pleasurable than hearing the same sound after it has been converted into an electronic audio signal and re-converted back into audible sound. There can be many reasons for this perceived drop in quality. One reason resides in the sound reproduction process itself.

Many of the sounds we hear, especially musical notes, are often a composite. For example, a musical note having a basic pitch or fundamental frequency, usually contains components of the fundamental frequency called harmonics. These harmonics create the tonal quality or timbre of the sound, such as a musical note, that is often unique to the musical instrument or other sound producing source. In other words, these harmonics enrich the sound we hear. While the human ear typically cannot discern the individual harmonics, it can perceive the presence or absence of these harmonics as a respective increase or decrease in the quality of the sound. Devices for converting live sound into electronic audio signals (for example, microphones or similar devices) typically do not adequately register and convert the full quality of the live sound. Thus, the electronic audio signals do not include many of the original harmonics. Numerous sound reproduction systems such as, for example, equalizers and tone controls have been developed in an attempt to add harmonic enhancement to such deficient audio signals. However, these systems are often very sophisticated and expensive and the sound quality produced with such systems still falls short of the original quality of the sound heard live.

Another reason reproduced sound is often perceived to have a lower quality than live sound can be attributed to the environment in which the sound is produced and recorded. For example, music played in an open field typically sounds one dimensional because much of the sound waves dissipate into the field and are not heard by a listener. On the other hand, music played in an acoustically designed room usually sounds richer and fuller, and individual sound sources, for example, musical instruments, are typically more distinguishable. One reason for this difference is that the sound heard by the listener includes high quality reverberations which combine to produce audible sound with a greater high quality harmonic content.

Not all reproduced sound originates in an acoustically designed environment and therefore does not have the benefit of such high quality reverberations. Even when an acoustically designed environment is used, high quality reverberations may get lost in the recording process, for instance, if the sound converting equipment (for example, a microphone or the like) is unable to register them.

Another problem with reproduced sound, such as music, is that it can become distorted when heard at high volumes. It is often difficult to clearly hear the words being sung in a song or distinguish one musical instrument from another as the volume increases.

An additional problem is that the quality of recorded music being played in a room can vary depending upon the room geometry and upon where the listener is located in the room with respect to the sound source (for example, speakers). When this occurs, the music sounds better at one or more specific locations in the room. Such locations are often referred to as sweet spots. Thus, in order to enjoy the full potential of the recorded music, a listener is forced to remain at these sweet spots.

Various sophisticated and expensive systems have been developed in an effort to produce an enhanced electronic audio signal which, when converted into audible sound, is perceived as more closely duplicating the experience of hearing the original live sound in an acoustically designed environment.

MODERN ELECTRONICS REFERENCE MANUAL, John Markus, 1980 McGraw-Hill, ISBN 0-07-040446-1, pages 53, 60 and 61; and 273 SCHALTUNGEN; Elektor Verlag GmbH, 1980, ISBN 3-921608-03-1, pages 174 and 175, circuit 231: "Entzerrer" disclose conventional audio control circuits including the classic bass/treble boost/cut circuit. The frequency response of an audio system can be varied. Transformers are used in audio amplifiers to match the respective input and output impedance. They use tight magnetic coupling in order to avoid losses and to achieve a large flat frequency response.

300 SCHALTUNGEN; Elektor Verlag GmbH, 1979, ISBN 3-921608-09-0, page 15, circuit 16: "Telefon-Mithöregerät"; and 273 SCHALTUNGEN; Elektor Verlag GmbH, 1980, ISBN 3-921608-03-1, page 75, circuit 93: "Mithörverstärker für das Telefon" disclose circuits intended for eavesdropping the stray magnetic field induced by the hybrid transformer in conventional telephones. These circuits reproduce enough of the original signal to enable the monitored conversation to be understood. There is no hint to influence the overall audio frequency response in a specific way.

The present invention is an improvement thereon which is relatively inexpensive and uncomplicated.

### SUMMARY OF THE INVENTION

In accordance with the present invention, methods and apparatus are provided for simply and inexpensively enhancing an electronic audio signal in such a way that the quality of audible sound produced from the audio signal more closely approaches that of the original sound as if heard live in an acoustically designed environment. The present invention improves the harmonic quality of an electronic audio signal by amplifying enhancing harmonics in the audio signal. Sound produced from an audio signal enhanced in accordance with the present invention appears to resist becoming distorted at high volumes and tends to eliminate, or at least significantly reduce, the formation of sweet spots.

To these ends, and in accordance with the principles of the present invention, the electronic audio signal is transmitted through a magnetic coil audio energy transfer system which enhances the electronic audio signal in such a way that audible sound produced from the enhanced audio signal is perceptibly richer and fuller. More specifically, the electronic audio signal is electrically transmitted through an electromagnetic field inducing coil to generate a field signal correlated to the original electronic audio signal. The field signal is then weakly or loosely coupled to a field receptor which converts the field signal into an enhanced, but weak, electronic audio signal which may then be amplified, if necessary, for reproduction on conventional audio reproducing equipment, such as speakers and the like. With weak or loose coupling, only a small portion of the electromagnetic field set up by the inducing coil cuts or passes through the field receptor. The weak coupling of the induced field signal to the receptor results in the electronic audio signal, and thus sound generated from the signal, being enhanced by the accentuation of desirable harmonics.

Weak or loose coupling between the inducing coil and the field receptor causes the well known negative signal distortion of the high frequencies being favored and low frequencies being attenuated. The present invention is predicated upon the discovery that along with this type of undesirable distortion or degradation there is also a desirable distortion or enhancement. It is believed that this harmonic enhancement remained undetected, until now, because the negative distortion (i.e., favoring of high frequencies at the expense of low frequencies) made such harmonic enhancement unrecognizable. Because the undesirable distortion associated with weak coupling is so well established and well known and the discovered harmonic enhancement unknown, weak coupling has been avoided, not embraced, as in the present invention. The inducing coil and the field receptor are weakly or loosely coupled in order to promote this undesirable distortion because of the previously unknown harmonic enhancement.

It is believed that the field inducing coil may be a wire winding with at least one turn, but it is desirable for the inducing coil to be a wire winding with a plurality of turns. It is believed that the receptor may be an electromagnetically conductive wire, plate, tube or other structure, but it is desirable for the field receptor to be a coil with a plurality of turns. It is desirable for the field inducing coil and the field receptor coil to have the same number of turns, and even more desirable for the field receptor coil to have more turns than the field inducing coil. The inducing and receptor coils may each be mounted on a separate core or both mounted on a single shared core. It is desirable for the cores to be non-permeable or low permeable cores, for example, air, plastic and cardboard cores.

By virtue of the foregoing, there is thus provided a simple and inexpensive apparatus and method for enhancing an electronic audio signal so as to have a quality when aurally reproduced approaching that of original live sound as heard in an acoustically designed environment.

The objectives, features and advantages of the present invention will become further apparent upon consideration of the following description and the appended drawings.

### BRIEF DESCRIPTION OF THE DRAWINGS

Fig. 1 is a block schematic diagram of an audio signal enhancing apparatus in accordance with the principles of the present invention;
Fig. 2 is a perspective view of one embodiment of an inducing coil and a field receptor coil according to the present invention;
Fig. 3 is a circuit diagram of a dual channel audio signal enhancing apparatus similar to the apparatus of Fig. 1; and
Fig. 4 is a diagrammatic sectional side view of an alternative embodiment of an inducing coil and a field receptor coil according to the present invention.

### DETAILED DESCRIPTION OF THE INVENTION

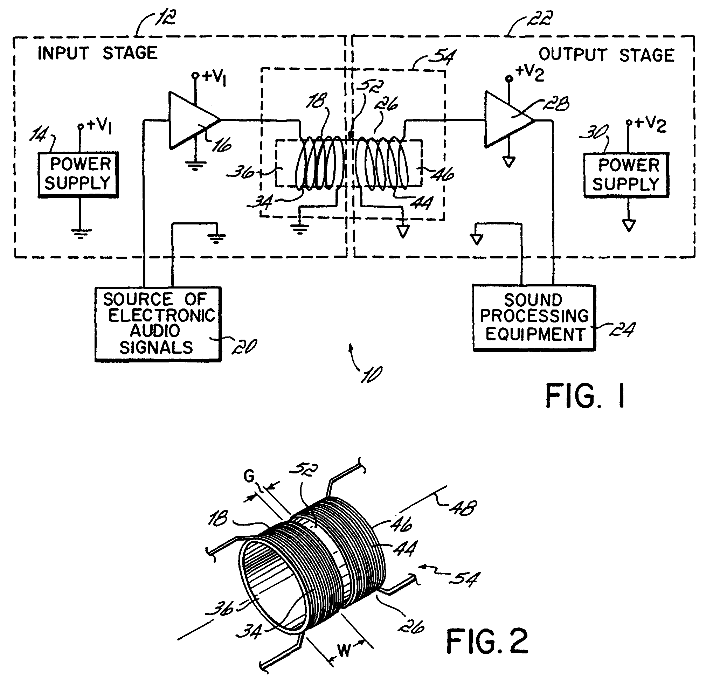

Referring to Fig. 1, there is shown one embodiment of a system 10 for enhancing electronic audio signals according to the principles of the present invention. System 10 includes an input stage 12 having power supply 14, input amplifier 16, and electromagnetic field inducing coil 18 through which multiple frequency input electronic audio signals are driven by amplifier 16 to generate a field signal correlated to the original input signal from a source 20 of electronic audio signals, such as a microphone, magnetic tape player, optical disc player, radio receiver, television audio receiver, telephone receiver or the like. System 10 also includes an output stage 22 for converting the generated field signals from input stage 12 into electronic audio signals which are enhanced according to the principles of the present invention and which may be reproduced into audible sound by conventional sound producing equipment 24, such as speakers and the like, or recorded onto a recording medium. Output stage 22 includes a field receptor 26 connected to output amplifier 28 which is powered by power supply 30. Field receptor 26 is positioned to receive very weak portions of the field signal created by coil 18 without inducing any appreciable amounts of undesirable feedback currents in coil 18.

Input amplifier 16 is a power amplifier which greatly amplifies and drives the input signal from source 20 through coil 18 of input stage 12 with sufficient strength to be received by receptor 26 for conversion into an enhanced electronic audio signal comprising the original input signal plus additional desirable harmonics. The field signal thus induced at coil 18 is weakly coupled to field receptor 26 of output stage 22. That is, the receptor 26 is placed within the field created by coil 18 but at a sufficient distance electromagnetically so as to receive the enhanced signals without introducing undesirable feedback in coil 18. Weakly coupled coil 18 and receptor 26 form a magnetic coil audio energy transfer system 54.

It is believed that coil 18 may be a single-turn coil of insulated wire 34 wound on a core 36 and that receptor 26 may be a conductive wire, tube or plate. However, it is desirable for both coil 18 and receptor 26 to be a multiple-turn coil of insulated magnetic wire 34 and wire 44, respectively, with the same number of turns. While coils 18 and 26 are shown as being cylindrical or circular in shape, the present invention is not intended to be so limited. Receptor coil 26 is wound on a core 46 which desirably forms part of the same core as core 36. In response to the field signal from coil 18, the enhanced electronic audio signal is generated in the receptor coil 26 but, because of the weak coupling, at a very low amplitude compared to the input signal driven through coil 18. The enhanced signal is so weak as it passes through receptor coil 26 that any field signal that the enhanced signal may induce is too weak to generate a significant feedback signal of its own in coil 18. The output of coil 26 is connected to output amplifier 28 in order to amplify the enhanced signal enough to be used by the sound reproduction equipment 24.

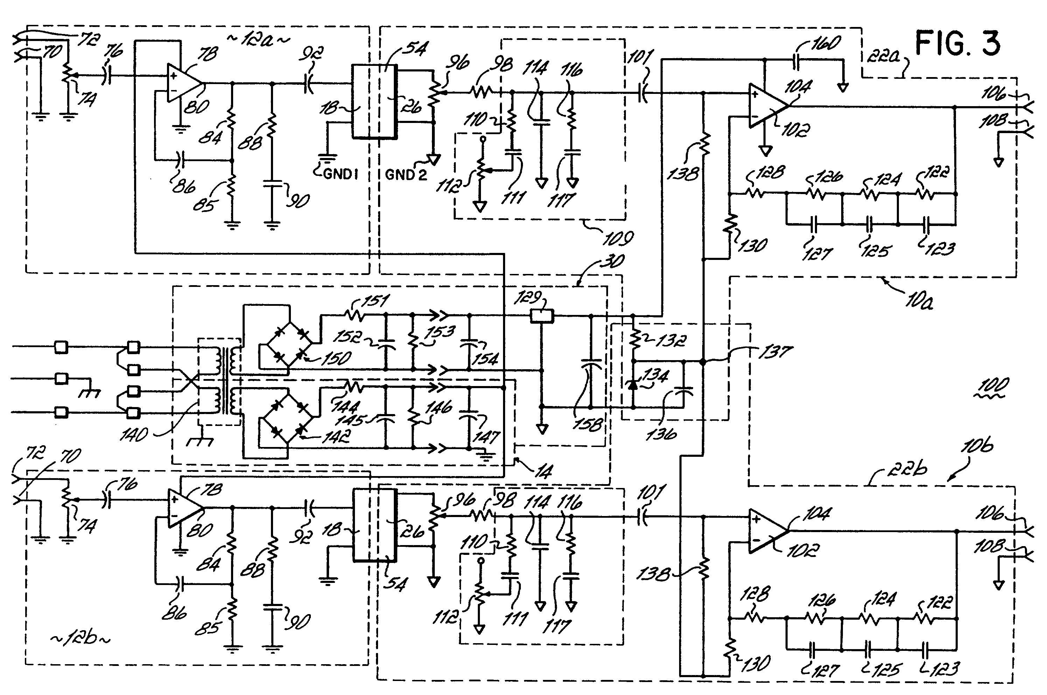

It will be appreciated that the field signal induced by coil 18 is weaker for lower frequencies than for higher frequencies. Therefore, the lower frequencies of the enhanced audio signal generated by receptor coil 26 are weaker than its higher frequency components. In other words, before it is amplified, the high frequency end of the enhanced audio signal has a higher amplitude (power level) than its low frequency end as compared to the original input audio signal driven through coil 18. It is therefore desirable for the output amplifier 28 to include a frequency shaping network 109 (see Fig. 3) which favors the low frequencies and attenuates the high frequencies so that the net result is a fairly flat frequency response when comparing the input audio signal before it enters input stage 12 and the enhanced audio signal as it leaves output stage 22.

As seen in Fig. 2, it is desirable for cores 36 and 46 to each form part of a single core member 52 such that coils 18 and 26 are coaxial along central axis 48 and spaced apart by a distance G. Although shown as a tube of cardboard, plastic or other suitable material with a circular cross-section, core 52 could have other cross-sections, such as rectangular, and could be a solid bar of acrylic or other sufficiently low permeability material. By being wound on a single core 52, it can be seen that coils 18 and 26 of energy transfer system 54 appear as the primary and secondary, respectively, of a lossy transformer. That is, the coupling between the coils 18 and 26 is deliberately weak so that there is little, if any, actual transformer action between the coils. Rather, coil 26 is believed to act primarily as a receptor of the field induced by coil 18 and is thus positioned relative to coil 18 so as not to significantly distort the enhancement of the input signal. The use of low permeability cores is desired and contributes to the weak coupling between the coils as is advantageous in the present invention. Also, by using one or more low permeability cores, such as with a permeability of approximately 1 or unity, the coils 18 and 26 can be kept close enough together to enable the input and output stages 12 and 22 to be housed in a relatively small package. Use of higher permeability cores, and perhaps even a ferromagnetic core, may suffice although the spacing between the coils will likely become large to maintain the weak coupling. Additionally, other than a coil, it is believed that receptor 26 could instead be a magnetically conductive plate, length of wire, tube or other structure which will receive and convert the field induced by coil 18 to a new and enhanced electronic audio signal.

To enhance the operation of system 10, it is desired that the input stage 12 and output stage 22 be well isolated, electrically and electromagnetically (except for the weak field coupling through system 54, at the interface of coils 18 and 26). To this end, separate power supplies 14 and 30 are provided in the respective stages 12 and 22, each with a separate ground. Also, each of the power supplies 14, 30 is kept physically remote from both stages 12, 22 or shielded from stages 12, 22 such as with shielding techniques and materials well known in the art.

A conventional audio signal source 20 (such as a microphone, magnetic tape player, optical disc player, radio receiver, television audio receiver, telephone receiver or the like) is usually connected to a sound producing device 24, such as a speaker. When the device 24 converts the electronic audio signal from conventional source 20 into audible sound, the sound produced does not have the degree of richness and fullness (the quality) that the original live sound possessed before being recorded. The quality of the audio sound produced is substantially enhanced by the introduction of the present inventive system 10 between the source 20 and the device 24. The electronic audio signal output from signal source 20 is connected to the input stage 12 and the output of output stage 22 is connected to the input of sound converting device 24 so that any electronic audio signal must pass through the magnetic coil audio energy transfer system 54 before being converted into audible sound. When this audible sound is heard by a listener, its quality is enhanced to the point of sounding as if the original performance were being played live and in an acoustically superior environment. Preferably, two systems 10 (i.e., dual channels) are used, one for each respective channel of a stereo sound reproduction system.

One dual channel version of system 10 was built with the following commercially available electronic components:
(a) Dual Channel Input Amplifier (16) - Realistic S-20 solid state stereo 12 watt amplifier, Model No. 31-B;
(b) Two Input Coils (18) - Each a standard speaker coil, rated at 8 ohms and 2 watts;
(c) Two Receptor Coils (26) - Each a standard speaker coil, rated at 8 ohms and 2 watts; and
(d) Dual Channel Output Amplifier (28) - Realistic stereo 1.5 watt pre-amplifier, Model No. 42-2109.

The above speaker coils 18, 26 were taken from 3 inch diameter speakers manufactured by the Tandy Corporation, Model No. 40-248. Each winding 18, 26 had a width W (see Fig. 2) of about .15 inches (.38 cm), an inside diameter of approximately .52 inches (1.32 cm), and was formed by two layers of about 30 turns (about 60 turns total) of magnet wire having a length of approximately 105 inches (267 cm) and a diameter of about .005 inches (.013 cm), including its insulation. Each pair of windings 18, 26 were mounted coaxially on a single core 50 of solid acrylic having a rectangular cross section of approximately 3/4 by 1/4 of an inch (1.9 x .64 cm) and passing completely through both coils 18, 26. The gap G between the coils 18, 26 was on the order of approximately .060 inches (.152 cm). The Realistic amplifiers were also manufactured by the Tandy Corporation. Generally, the degree of amplification of the audio signal provided by the input amplifier 16 and the optimum gap G between the windings 18, 26 (see Fig. 2) are directly related. For example, with all other variables remaining the same, as the amplification of the audio signal by the input amplifier 16 increases, it is believed that the gap G will eventually need to be increased. As previously noted, the gap G is believed to also vary directly with the permeability of the core 52. This early embodiment of the present invention produced enhanced sound but also exhibited some undesirable characteristics. To overcome these problems, another dual channel embodiment of system 10 was built as now will be described with reference to Fig. 3.

Turning now to Fig. 3, there is shown a detailed schematic illustration of a dual channel or stereo version 100 of system 10 including a left side system 10a and an identical right side system 10b. Systems 10a and 10b share common input stage power supply 14 and common output stage power supply 30 as will be described. The input and output stages 12a, 12b and 22a, 22b of the two systems 10a, 10b are identical and therefore only the circuitry of system 10a will be described in any detail, it being understood that system 10b is the same.

More specifically, input stage 12a includes a first pair of electronic audio inputs 70, 72 connected respectively to the ground (GND1) of power supply 14 and of input stage 12a, and to 10 Kohm potentiometer 74. The wiper of potentiometer 74 is connected via 10 µF capacitor 76 to the non-inverting input of an LM383 operational amplifier 78. The output 80 of amplifier 78 is fed back to its inverting input from the junction of 1/2 watt grounded series resistors 84, 85 (200 ohm and 10 ohm, respectively), through 470µF capacitor 86. Output 80 of amplifier 78 is further connected to GND1 via the series branch of 1 ohm, 1/2 watt resistor 88 and .2 µF capacitor 90. Output 80 is next connected to the inducing coil 18 of magnetic coil audio energy transfer system 54 through 2,200 µF capacitor 92 to drive the electronic audio signal from inputs 70, 72 through coil 18 and induce the field signal as previously described.

Energy transfer system 54 includes field receptor 26 which is connected to a 1 Kohm potentiometer 96, the wiper of which is connected through 10 Kohm resistor 98 and 1 µF capacitor 101 to the non-inverting input of a LM1458N operational amplifier 102. The coil 18 and receptor 26 are each the same standard 8 ohm, 2 watt speaker coil found in the previously described version of system 10 using commercially available electronic components. Energy transfer system 54, both coil 18 and receptor 26, were fully encapsulated with a low permeability polymeric potting material for structural integrity. DP-270, a black epoxy potting compound/adhesive manufactured by 3M, St. Paul, Minnesota, provided sufficient structural strength and low permeability. Both coils 18 and 26 are potted in their original cylindrical configuration and in the coaxial orientation shown in Fig. 2, with a gap G of approximately .025 inches (.0635 cm). Output 104 of amplifier 102 is connected to enhanced audio output port 106 which, in cooperation with grounded output port 108, provides the enhanced electronic audio signal to reproducing equipment 24 as previously described. The junction of resistor 98 and capacitor 101 is connected to the output stage power supply ground (GND2) through a shaping circuit 109 comprised of three parallel circuit branches as follows: the series circuit of 5.1 Kohm resistor 110, .05 µF capacitor 111, and open ended 50 Kohm potentiometer 112; .002 µF capacitor 114; and the series circuit of 5.1 Kohm resistor 116 and .1 µF capacitor 117.

The output 104 of amplifier 102 is connected back to its inverting input via the series circuit of: parallel 499 Kohm resistor 122 and .005 µF capacitor 123; parallel 49.9 Kohm resistor 124 and .01 µF capacitor 125; parallel 10.0 Kohm resistor 126 and .005 µF capacitor 127; and 10.0 Kohm resistor 128. The inverting input of output amplifier 102 (as well as the inverting input of the comparable output amplifier in system 10b) is connected to a regulated voltage from regulator 129 of power supply 30 via 1.5 Kohm resistor 130 to the junction of 510 ohm resistor 132 and 5 volt zener diode 134 and 10 µF capacitor 136 which, at node 137, is at 5 volts. The non-inverting input of output amplifier 102 is similarly coupled to the 5 volt reference 137 via 100 Kohm resistor 138.

With respect to the power supplies 14 and 30, a dual transformer 140 provides about 14 volts to the balance of each supply 14 and 30, as will now be described. Input stage power supply 14 includes a diode bridge 142 which produces a full-wave rectified output from one 14 volt output of dual transformer 140. The full-wave rectified output is smoothed (filtered) by the circuit comprised of 1 ohm, 1/2 watt resistor 144, 2200 µF capacitor 145, 10 Kohm, 1/2 watt resistor 146 and 1 µF capacitor 147 to provide a nominal 18 volt unregulated supply and ground (GND1) for each of the input stages 12a and 12b. Similarly, the output stage power supply 30 includes a full-wave rectifier diode bridge 150 connected to the other 14 volt output of dual transformer 140. The output of bridge 150 is smoothed by the circuit comprised of 100 ohm, 1/2 watt resistor 151, 470 µF capacitor 152, 10 Kohm, 1/2 watt resistor 153 and 1 µF capacitor 154 to provide a nominal unregulated 18 volts to voltage regulator 129. The output of the voltage regulator 129 is bypassed to ground (GND2) via 10 µF smoothing capacitor 158 and .01 µF smoothing capacitor 160 and provides a regulated 12 volt supply and ground (GND2) for each of the output stages 22a and 22b. Capacitor 158 provides filtering for lower frequencies and capacitor 160 provides filtering for higher frequencies. Note that the input amplifiers 78 of each system 10a and 10b have been provided in separate integrated circuit packages and independently powered from supply 14 whereas output amplifiers 102 of each output stage 22a and 22b have been provided in a single integrated circuit package and powered in common from power supply 30.

To prevent interference with the respective audio signals, it is desirable for that portion of power supplies 14, 30 before respective capacitors 147 and 154 to be kept remote from the input and output stages or, as previously discussed, shielded. In addition, the energy transfer system 54 (field inducing coil and field receptor) for each channel may also need to be shielded to protect system 54 from any unwanted interference external or otherwise.

In operation, the electronic audio signal for each channel is connected, by a standard jack or the like (not shown), to the respective input ports 70, 72. As will be appreciated, the electronic audio signal will normally include a wide range of audio frequencies. The respective input levels are adjusted at potentiometers 74 so that the input signal levels of the two channels are about equal and to allow input amplifiers 78 to amplify the input signals to the maximum extent possible without clipping or otherwise adversely distorting the input signals. The audio signals are then enhanced through energy transfer system 54 and the enhanced signals adjusted in level by respective potentiometers 96 and for the desired flat frequency response by respective potentiometers 112 which may also be used to alter the shaping networks 109 somewhat to adjust the tonal quality as desired for the listener. The enhanced audio signals are then amplified by amplifier 102 and connected through outputs 106 and 108 (such as by a standard jack) to sound reproduction equipment 24, such as another amplifier or speaker system, and is converted into audible sound. Alternatively, equipment 24 may be another recorder of electronic audio signals for recording the enhanced audio signals onto some form of recording medium, for example, magnetic tape or optical disk.

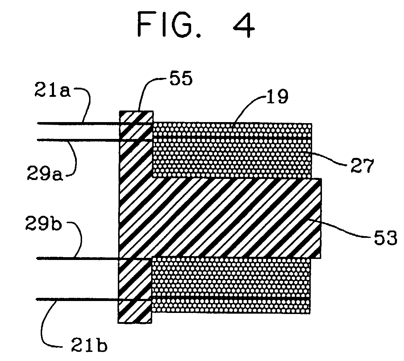

Referring to Fig. 4, it has been found more desirable for the magnetic coil audio energy transfer system 54 to be formed with a receptor coil 27 having a greater number of turns than its inducing coil 19. The receptor coil 27 is wrapped around a cylindrical core 53 made according to the principles of the present invention. For example, core 53 could be solid, made with a low permeability plastic material, and have a shoulder flange 55 at one end. Core 53 could also be an air core formed with or without a tube (similar to core 52) of cardboard, plastic or other suitable material. The inducing coil 19 is wrapped around the outside of the receptor coil 27. Each coil 19 and 27 has respective leads 21a, 21b and 29a, 29b, with each lead passing through a hole formed through flange 55. Each of the leads 21a, 21b and 29a, 29b are adapted for being connected into an appropriate circuit. By increasing the number of turns in the receptor coil 27 compared to the inducing coil 19, an electronic audio signal driven through the inducing coil 19 does not have to be amplified as much in order to induce a signal of sufficient strength in the receptor coil 27.

While the present invention has been described and illustrated with reference to a number of embodiments, and while these embodiments have been described in considerable detail, there is no intention to restrict or in any way limit the scope of the appended claims to such detail. Additional advantages and modifications will readily appear to those skilled in the art. For instance, if the music or vocals from a compact disc player, in the form of electronic audio signals, is transmitted through system 100 of the present invention and the resulting enhanced electronic audio signal re-recorded onto a cassette tape using a cassette player/recorder, the quality of the music or vocals produced from the recorded cassette tape has been found to be perceptibly better than the same music or vocals produced directly from the compact disc. This occurs even though the compact disc format is widely recognized as producing superior sound quality compared to the cassette tape format. It is believed that the present invention can be used to enhance electronic audio signals from sound converting equipment, for example a microphone or the like, before being either recorded onto a recording medium (for example, magnetic tape or optical disk), transmitted through the air (for example, for television or cellular telephone) or converted directly into audible sound (for example, at a concert or play).

The invention in its broader aspects is therefore not limited to the specific details, representative apparatus and method, and illustrative examples shown and described. Accordingly, departures may be made from such details without departing from the scope of the general inventive concept of the present invention.

## Claims

1. An apparatus (10) for enhancing the quality of electronic audio signals by altering the amplitude of selected frequencies in the audio signal, said apparatus (10) being characterized by:
an input stage (12) having a field inducing coil (18) through which input audio signals are to be transmitted to set-up an electromagnetic field; and
an output stage (22) having an electromagnetic field receptor (26) and an output, said field inducing coil (18) and said electromagnetic field receptor (26) being weakly coupled such that, when an input audio signal is transmitted through said field inducing coil (18), an enhanced audio signal is available at said output having an improved harmonic quality compared to that of the input audio signal.

2. The apparatus (10) as set forth in claim 1, wherein said electromagnetic field receptor (26) is a receptor coil (44) with a plurality of turns, and said inducing coil (18) and said receptor coil (44) are weakly coupled such that when an input audio signal is transmitted through said field inducing coil (18), an enhanced audio signal is available at said output.

3. The apparatus (10) as set forth in claim 2, wherein said field receptor coil (44) has a greater number of turns than said field inducing coil (18).

4. The apparatus (10) as set forth in claim 1, wherein said apparatus (10) includes a sound producing device (24) connected to said output for converting the enhanced audio signal into audible sound.

5. The apparatus (10) as set forth in claim 1, wherein said apparatus (10) includes a recorder (24) connected to said output for recording the enhanced audio signal onto a recording medium.

6. The apparatus (10) as set forth in claim 1, wherein said apparatus (10) includes a transmitter (24) connected to said output for transmitting the enhanced audio signal from one location to another.

7. A method of enhancing the quality of electronic audio signals by altering the amplitude of selected frequencies in the audio signal, said method being characterised by the steps of:
providing at least one input audio signal;
transmitting the at least one input audio signal through a field inducing coil (18), thereby setting up at least one electromagnetic field; and
weakly coupling the at least one electromagnetic field to an electromagnetic field receptor (26) to generate at least one enhanced audio signal in the field receptor (26) having an improved harmonic quality compared to that of the input audio signal.

8. The method as set forth in claim 7, said method further comprising the step of:
processing the enhanced audio signal into audible sound.

9. The method as set forth in claim 7, said method further comprising the step of:
transmitting the enhanced audio signal from one location to another.

10. The method as set forth in claim 7, said method further comprising the step of:
recording the enhanced audio signal onto a recording medium.

## Patentansprüche

1. Einrichtung (10) zum Verbessem oder Anreichern der Qualität von elektronischen Audiosignalen durch Ändern der Amplitude von ausgewählten Frequenzen in dem Audiosignal, welches Gerät (10) gekennzeichnet ist durch:
- eine Eingangsstufe (12) mit einer feldinduzierenden Spule (18), durch welche Eingangs-Audiosignale zu übertragen sind, um ein elektromagnetisches Feld aufzubauen; und
- eine Ausgangsstufe (22) mit einem elektromagnetischen Feldempfänger (26) und einem Ausgang, wobei die feldinduzierende Spule (18) und der elektromagnetische Feldempfänger (26) schwach so gekoppelt sind, daß bei Übertragen eines Audiosignals durch die feldinduzierende Spule (18) ein verbessertes oder angereichertes Audiosignal an dem Ausgang ansteht, das eine verbesserte harmonische Qualität gegenüber demjenigen des Eingangs-Audiosignals besitzt.

2. Einrichtung (10) nach Anspruch 1, bei welcher der elektromagnetische Feldempfänger (26) eine Empfangsspule (44) ist, die mehrere Wicklungen besitzt und die induzierende Spule (18) und die Empfangsspule (44) schwach so gekoppelt sind, daß bei Übertragen eines Eingangs-Audiosignals durch die feldinduzierende Spule (18) ein verbessertes Audiosignal am Ausgang verfügbar ist.

3. Einrichtung (10) nach Anspruch 2, bei der die Feldempfängerspule (44) eine größere Anzahl von Wicklungen als die feldinduzierende Spule (18) besitzt.

4. Einrichtung (10) nach Anspruch 1, bei der die Einrichtung (10) ein tonerzeugendes Gerät (24) beinhaltet, das mit dem Ausgang gekoppelt ist, zum Umsetzen des verbesserten oder angereicherten Audiosignals in hörbaren Ton.

5. Einrichtung (10) nach Anspruch 1, bei der die Einrichtung (10) eine Aufzeichnungseinrichtung (24) besitzt, die mit dem Ausgang zum Aufzeichnen des verbesserten oder angereicherten Audiosignals auf ein Aufzeichnungsmedium gekoppelt ist.

6. Einrichtung (10) nach Anspruch 1, bei der die Einrichtung (10) einen Transmitter oder ein Übertragungsglied (24) besitzt, der mit dem Ausgang gekoppelt ist, zum Übertragen des angereicherten oder verbesserten Audiosignals von einem Ort zum einem anderen.

7. Verfahren zum Verbessern oder Anreichern der Qualität von elektronischen Audiosignalen durch Ändern der Amplitude von ausgewählten Frequenzen in dem Audiosignal, welches Verfahren durch folgende Schritte gekennzeichnet ist:
- Bereitstellen zumindest eines Eingangs-Audiosignals;
- Übertragen des zumindest einen Eingangs-Audiosignals durch eine feldinduzierende Spule (18), wodurch zumindest ein elektromagnetisches Feld aufgebaut wird; und
- schwaches Koppeln des zumindest einen elektromagnetischen Feldes zu einem Empfänger (26) für ein elektromagnetisches Feld, um zumindest ein verbessertes oder angereichertes Audiosignal in dem Feldempfänger (26) zu erzeugen, das eine verbesserte harmonische Qualität im Vergleich zu dem Eingangs-Audiosignal besitzt.

8. Verfahren nach Anspruch 7, bei dem das Verfahren weiter den folgenden Schritt beinhaltet: Verarbeiten des verbesserten oder angereicherten Audiosignals in hörbaren Ton.

9. Verfahren nach Anspruch 7, bei dem das Verfahren auch den folgenden Schritt beinhaltet: Übertragen des verbesserten oder angereicherten Audiosignals von einem Ort zu einem anderen.

10. Verfahren nach Anspruch 7, welches Verfahren auch den folgenden Schritt umfaßt:
Aufzeichnen des verbesserten oder angereicherten Audiosignals auf ein Aufzeichnungsmedium.

## Revendications

1. Dispositif (10) pour améliorer la qualité de signaux audio électroniques en modifiant l'amplitude de fréquences sélectionnées dans le signal audio, ledit dispositif (10) étant caractérisé par :
un étage d'entrée (12) comprenant une bobine d'induction de champ (18) à travers laquelle les signaux audio d'entrée doivent être transmis pour établir un champ électromagnétique ; et
un étage de sortie (22) comprenant un récepteur de champ électromagnétique (26) et une sortie, ladite bobine d'induction de champ (18) et ledit récepteur de champ électromagnétique (26) étant faiblement couplés de façon que, lorsqu'un signal audio d'entrée est transmis à travers ladite bobine d'induction de champ (18), un signal audio amélioré soit disponible au niveau de ladite sortie, ayant une qualité d'harmonique améliorée par rapport à celle du signal audio d'entrée.

2. Dispositif (10) selon la revendication 1, dans lequel ledit récepteur de champ électromagnétique (26) est une bobine réceptrice (44) avec une pluralité de tours et ladite bobine d'induction (18) et ladite bobine réceptrice (44) sont faiblement couplées, de façon que lorsqu'un signal audio d'entrée est transmis à travers ladite bobine d'induction de champ (18), un signal audio amélioré soit disponible à ladite sortie.

3. Dispositif (10) selon la revendication 2, dans lequel ladite bobine réceptrice de champ (44) a un plus grand nombre de tours que ladite bobine d'induction de champ (18).

4. Dispositif (10) selon la revendication 1, dans lequel ledit dispositif (10) comprend un dispositif de production de son (24) connecté à ladite sortie pour convertir le signal audio amélioré en son audible.

5. Dispositif (10) selon la revendication 1, dans lequel ledit dispositif (10) comprend un dispositif d'enregistrement (24) ccnnecté à ladite sortie pour enregistrer le signal audio amélioré sur un support d'enregistrement.

6. Dispositif (10) selon la revendication 1, dans lequel ledit dispositif (10) comprend un émetteur (24) connecté à ladite sortie pour émettre le signal audio amélioré d'un emplacement à un autre.

7. Procédé d'amélioration de la qualité de signaux audio électroniques en modifiant l'amplitude de fréquences sélectionnées dans le signal audio, ledit procédé étant caractérisé par les étapes consistant à :
fournir au moins un signal audio d'entrée ;
transmettre le au moins un signal audio d'entrée à travers une bobine d'induction de champ (18), de manière à établir au moins un champ électromagnétique ; et
coupler faiblement le au moins un champ électromagnétique à un récepteur de champ électromagnétique (26) pour générer au moins un signal audio amélioré dans le récepteur de champ (26), ayant une qualité d'harmonique améliorée par rapport à celle du signal audio d'entrée.

8. Procédé selon la revendication 7, ledit procédé comprenant en outre l'étape consistant à :
traiter le signal audio amélioré en son audible.

9. Procédé selon la revendication 7, ledit procédé comprenant en outre l'étape consistant à :
transmettre le signal audio amélioré d'un emplacement à un autre.

10. Procédé selon la revendication 7, ledit procédé comprenant en outre l'étape consistant à :
enregistrer le signal audio amélioré sur un support d'enregistrement.
